(19) **Europäisches Patentamt / European Patent Office / Office européen des brevets**

(11) **EP 3 470 366 B1**

(12) # EUROPEAN PATENT SPECIFICATION

(45) Date of publication and mention
of the grant of the patent:
**08.07.2020 Bulletin 2020/28**

(51) Int Cl.:
**B81B 7/00** *(2006.01)* **G01P 1/02** *(2006.01)*

(21) Application number: **18196462.8**

(22) Date of filing: **25.09.2018**

(54) **REDUCING VIBRATION OF A MEMS INSTALLATION ON A PRINTED CIRCUIT BOARD**

REDUZIERUNG VON VIBRATION EINER MEMS INSTALLATION AUF EINER LEITERPLATTE

RÉDUCTION DES VIBRATIONS D'UNE INSTALLATION MEMS SUR UNE CARTE DE CIRCUIT IMPRIMÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.10.2017 FI 20175898**

(43) Date of publication of application:
**17.04.2019 Bulletin 2019/16**

(73) Proprietor: **Murata Manufacturing Co., Ltd.
Kyoto 617-8555 (JP)**

(72) Inventors:
• **Mäntyoja, Nikolai
  02200 Espoo (FI)**

• **Kaija, Kimmo
  02660 Espoo (FI)**
• **Nurmi, Sami
  04320 Tuusula (FI)**
• **Eskelinen, Jukka
  01800 Klaukkala (FI)**

(74) Representative: **Boco IP Oy Ab
Itämerenkatu 5
00180 Helsinki (FI)**

(56) References cited:
**EP-A1- 0 711 104**    **US-A1- 2006 231 949**
**US-A1- 2014 091 443**

## Description

## Field

The present invention relates to a method related to installation of micromechanical components. More particularly, the invention relates to a method of installation and an installation resulting from such method, which facilitate reduction of unwanted vibration of a MEMS device component body installed on a printed circuit board.

## Background

Micro-Electro-Mechanical Systems, or MEMS can be defined as miniaturized mechanical and electro-mechanical systems where at least some elements have a mechanical functionality. Since MEMS devices are created with the same or similar tools used to create integrated circuits, micromachines and microelectronics can be fabricated on the same piece of silicon.

MEMS devices comprising structures can be applied to quickly and accurately detect very small changes in physical properties. For example, a microelectronic gyroscope can be applied to quickly and accurately detect very small angular displacements, and a microelectronic accelerometer can be applied to detect acceleration.

A MEMS device may be packed into a standard integrated circuit (IC) component package that is typically placed on a printed circuit board (PCB), into which it is attached by soldering. Soldering is a well-known process in which two or more items are joined together by melting a filler metal called solder into the joint. The filler metal has a lower melting point than the adjoining metal. In industrial scale, wave soldering and reflow soldering processes are commonly used in assembling components on PCBs. In the reflow soldering process, a solder paste is applied on the printed circuit board using a stencil having openings at locations of contact pads of the printed circuit board. The solder paste is used to temporarily attach electrical components to their contact pads, after which the entire assembly is subjected to controlled heat, which melts the solder paste and permanently connects the joint(s). Thickness of the solder paste layer may be controlled by thickness of the stencil. The term thickness refers to vertical thickness of the layer of the solder paste along an axis collinear with the z-axis.

Like any electronic devices, MEMS devices may be placed into various types of component packages. When the purpose of a MEMS device is to detect motion or posture, the component package comprising the MEMS device may be subject to harsh environment, in which the component package is subject to various external forces caused by linear acceleration, rotation and/or vibration, for example. Examples of such environmental conditions are vehicular installations and various industrial applications.

A problem caused by a mechanically harsh environment is that a component package soldered on a PCB may be caused to resonate at one or more frequencies. The resonance frequency depends on the physical dimensions of the component package as well as characteristics of the materials used in the package itself as well as materials used for attaching the component package to the PCB. The problem is further increased by the requirement to have high q-factors in the MEMS device packages. This is because for being able to perform its intended task, the package of a MEMS device is not allowed to significantly dampen the mechanical signals that are to be detected. This causes the package resonance gain for a MEMS device package to be high by default.

The frequency of the resonances occurring in a soldered component package depends on the component package type. When the component package has clearly extending metal leads, the resonance frequencies are relatively low, facilitated by the metal leads that extend between the component package and the PCB. Examples of such well-known component package types are for example dual in-line packages (DIP), and various versions of small outline integrated circuit (SOIC) packages, for example wide SOIC, mini-SOIC, small-outline J-leaded packages (SOJ), small-outline packages (SOP), Shrink small-outline packages (SSOP), thin small-outline packages (TSOP), thin-shrink small-outline packages (TSSOP) and exposed pad packages. Lowest resonance frequency of such package may be in order of 5-15 kHz. Depending on the intended use of a MEMS sensor packed in any of such component package, such frequencies may cause significant error to MEMS sensor readings. For comparison, resonance frequencies of leadless packages, such as for example ceramic or plastic leadless chip carriers (LCC), various grid arrays, bump chip carriers (BCC), flat no-leads packages, including but not limited to quad-flat no-leads (QFN), dual-flat no-leads (DFN) packages, can be expected to be much higher frequencies than resonances for packages with leads.

## Description of the related art

Exemplary traditional methods to reduce environmental stress on installed component packages are known as conformal coating and underfilling.

Conformal coating refers to a thin polymeric film which conforms to the contours of a PCB to protect the board's components. A conformal coating acts as protection against harsh environments, for example moisture, dust, chemicals, temperature extremes and even mechanical protection. Assembly of conformal coating requires production process after soldering the components on the PCB, which process may comprise multiple phases. This increases production costs.

Underfilling refers to using an electrically-insulating adhesive under the component package. Underfilling improves both mechanical connection and heat bridge between the component and the underlying PCB, and reduces stress on solder joints. Underfilling may only be performed after the soldering process and, similarly to conformal coating, it requires additional production process steps, which increases the production cost.

Patent US 9,691,688 discloses a thin plastic leadless package with an exposed metal die paddle. Exposed metal die paddles are commonly used for transferring heat away from a packaged chip for example with quad-flat no-leads (QFN) type component packages. For efficient heat transfer, a galvanic connection is expected between the exposed metal die paddle of the component package and the PCB below it.

However, not all components can or have been designed to comprise an exposed paddle. The entire design of a component disposed in a component package with an exposed paddle shall be adapted for such package type from the scratch. Not all components may be disposed into a package having an exposed paddle for various reasons. Redesign of a component to fit in an exposed paddle package would lead to long research and development cycle, which as such already increases not only delay but also cost of the component.

In some known component package designs, for example MEMS component package designs, an exposed paddle is used on top of the component package body, where the metal layer of the exposed paddle facilitates electromagnetic compatibility (EMC) protection. In such component package designs, it is not a feasible option to change the placement of the exposed paddle to underneath the package body, in other words under the component chip disposed inside the package body, since this would deteriorate the EMC protection, subjecting the packaged component to unwanted electromagnetic interference. Inventors have found that conformal coating or underfilling may improve also the problem of resonances of the component package. However, as indicated above, these solutions increase complexity of the production process and thus cost of production. An exposed paddle package is not typically available for MEMS device packages. A solution is therefore needed for damping vibrations of a component package without increasing cost in the manufacturing process nor requiring redesign of the entire component or its packaging. US 2014/091443 A1 teaches a method for installing a MEMS component package comprising a body having outer surfaces of electrically non-conductive material and a plurality of electrically conducting leads protruding from the body, comprising applying simultaneously a solder pad on a blind pad exposed on a printed circuit board surface and solder paste for electrically joining the leads to pin pads exposed on the printed circuit board surface, the blind pad disposed at a location collocated with an intended location of the body and the solder pad collocated with the blind pad on the surface of the printed circuit board; placing the MEMS component package on the printed circuit board surface, wherein the solder paste applied for joining the leads temporarily attaches the leads to the pin pads of the printed circuit board; subjecting the printed circuit board to controlled heat configured to melt the solder paste to electrically couple the leads to the pin pads of the printed circuit board and to simultaneously melt the solder pad thereby coupling the material of the solder pad to the blind pad on the printed circuit board and the material of the solder pad attaching with a non-galvanic contact directly to the electrically non-conductive plastic bottom of the body. Further, US 2014/091443 A1 discloses a printed circuit board having a MEMS component package installed on it, the MEMS component package comprising a body having outer surfaces of electrically non-conductive material and a plurality of electrically conducting leads protruding from the body and soldered to pin pads of the printed circuit board, further comprising a blind pad of the printed circuit board disposed at a location collocated with the location of the body; and a piece of solder coupling the body to the blind pad on the printed circuit board, the piece of solder attaching with a non-galvanic contact directly to the electrically non-conductive plastic bottom of the body.

## Summary

An object is to provide a method and apparatus so as to solve the problem of damping vibrations of a MEMS component package installed on a printed circuit board without increasing manufacturing cost. The objects of the present invention are achieved with a method according to claim 1. The objects of the present invention are further achieved with a printed circuit board according to claim 11.

The preferred embodiments of the invention are disclosed in the dependent claims.

According to the invention a method for installing a MEMS component package is provided. The MEMS component package comprises a body having outer surfaces of electrically non-conductive material and a plurality of electrically conducting leads protruding from the body. The method comprises applying simultaneously at least one solder pad on at least one blind pad exposed on a printed circuit board surface, and solder paste for electrically joining the leads to pin pads exposed on the printed circuit board surface. The at least one blind pad is disposed at a location collocated with an intended location of the body, and the at least one solder pad is collocated with the at least one blind pad on the surface of the printed circuit board. The MEMS component package is placed on the printed circuit board surface, wherein the solder paste applied for joining the leads temporarily attaches the leads to the pin pads of the printed circuit board. The printed circuit board is subjected to controlled heat configured melt the solder paste to electrically couple the leads to the pin pads of the printed circuit board, and to simultaneously melt the at least one solder pad. The melting is configured to transform the at least one solder pad into a solder bump that couples the body to the at least one blind pad on the printed circuit board. The solder bump attaches with a non-galvanic contact directly to the flat, electrically non-conductive plastic bottom of the body.

According to a second aspect, the solder pad and the pin pads are applied using a stencil, and vertical distance of the body from the at least one blind pad is greater than the thickness of the stencil, and all maximum horizontal dimensions of the at least one solder pad are equal to or greater than the respective horizontal dimensions of the respective at least one blind pad.

According to a third aspect, the printed circuit board is coated with a solder mask having at least one opening, wherein the solder mask opening is collocated with the respective blind pad, and wherein all horizontal dimensions of the solder pad are equal to or greater than respective horizontal dimensions of the solder mask opening.

According to a fourth aspect, the solder pad and the pin pads are applied using a stencil, and vertical distance of the body from the at least one blind pad is equal to or less than thickness of the stencil, and the horizontal dimensions of the at least solder pad are equal to or less than the respective horizontal dimensions of the respective at least one blind pad.

According to a fifth aspect the shape of the at least one blind pad is any one of circular, rectangular and rectangular with rounded corners, and wherein the shape of the at least one solder pad is respectively one of circular, rectangular and rectangular with rounded corners.

According to a sixth aspect, the solder pad transforms into a rounded solder bump when subject to controlled heat, the rounded solder bump having a shape of any one of circular and rounded rectangular. According to a seventh aspect, the electrically non-conductive bottom of the body comprises any one of plastic, ceramic, glass and silicon. According to an eighth aspect, the at least one solder pad comprises the same solder paste material that is applied for joining the leads to the pin pads.

According to a ninth aspect, the printed circuit board comprises a single blind pad disposed under the intended location of the body.

According to a tenth aspect, the printed circuit board comprises two or more blind pads disposed under the intended location of the body. According to an eleventh aspect, the solder paste is any one of a tin-based soft solder and a lead-free tin-silver-copper alloy.

According to the invention, a printed circuit board having a MEMS component package installed on it is provided. The MEMS component package comprises a body having outer surfaces of electrically non-conductive material and a plurality of electrically conducting leads protruding from the body and soldered to pin pads of the printed circuit board. The printed circuit board installation comprises at least one blind pad of the printed circuit board disposed at a location collocated with the location of the body. The installation further comprises at least one solder bump configured to couple the body to the at least one blind pad on printed circuit board. The at least one solder bump attaches with a non-galvanic contact directly to the flat, electrically non-conductive plastic bottom of the body. According to another aspect, all maximum horizontal dimensions of the at least one solder bump are equal to or greater than the respective horizontal dimensions of the respective at least one blind pad.

According to further aspect, the printed circuit board is coated with a solder mask having at least one opening, wherein the solder mask opening is collocated with the respective blind pad, and wherein maximum horizontal dimensions of the solder bump are equal to or greater than respective horizontal dimensions of the solder mask opening.

According to a further aspect, the at least one blind pad is any one of circular, rectangular and rectangular with rounded corners, and the shape of the at least one solder bump is any one of circular and rounded rectangular.

The present invention is based on the idea of placing a solder pad under the component package, which solder pad attaches the package body to a blind pad disposed on the surface of the underlying printed circuit board. The solder pad attaches directly to the non-conducting body material of the component package during the same reflow process used for connecting its electrical contacts with the PCB, using the same standard soldering paste material. Thus, the joint between the solder pad and the body of the component package is not a traditional metal-metal solder joint, but it may be one of a plastic-metal, glass-metal, silicon-metal and a ceramic-metal interface. Preferably, the joint is a plastic-metal joint. While there is only non-conductive material on the package body side of the contact, the contact between the solder ball and the package body is non-galvanic. Such non-galvanic contact interface may have micro level surface form fit characteristics as well as a frictional engagement but causes no electrical coupling. With micro level surface form fit interface we mean that while the melted solder enters in the micro level irregularities at the surface of the component package, the solidifying, cooling solder forms a micro level surface that has a form that fits with that of the component body. The thermal conductivity of a plastic-metal joint is significantly smaller than that of a typical galvanic joint. The thermal conductivity of a glass-metal, a silicon-metal and a ceramic-metal joint is also smaller than that of a typical galvanic metal-metal joint, but more than that of a plastic-metal joint. Thus, a plastic-metal contact is preferred.

On the PCB side, the solder pad attaches to a blind pad on the PCB, which blind pad is exposed by an opening in a solder mask of the PCB, when there is a solder mask on the PCB. Typically, the blind pad is formed by a thin metal sheet pattern disposed on the face of the PCB similarly to pin pads configured for electrically connecting component leads (legs) to the PCB. Thus, the coupling between the solder pad and the blind pad is a traditional metal to solder joint, which is created by surface alloying. A proper, solderable blind pad may be designed with or without a solder mask. The size and the geometry of the blind pad and/or the associated solder mask opening define the soldering characteristics of the blind pad.

The present invention has the advantage that it enables damping vibrations of a component package without adding any extra manufacturing process phases. The only added cost is the cost of the additional solder paste needed for the solder pad, which is in practice negligible.

**Brief description of the drawings**

In the following the invention will be described in greater detail, in connection with preferred embodiments, with reference to the attached drawings, in which

> Figures 1 to 1f illustrate a cross-section of main phases of a MEMS package assembly process to a PCB.
>
> Figures 2a to 2b illustrates cross-sections of phases of a first alternative assembly process.
>
> Figures 3a to 3c illustrate cross-section of phases of a second alternative assembly process.
>
> Figure 4 illustrates layout of a first exemplary PCB and a stencil with a single circular blind pad.
>
> Figure 5 illustrates layout of a second exemplary PCB and a stencil with four circular blind pads.
>
> Figure 6 illustrates layout of a third exemplary PCB and a stencil with two oblong, rectangular blind pads.
>
> Figure 7 illustrates y-direction acceleration gain of a component body with and without solder pads disposed under the component body.

**Detailed description**

In this application, xy-plane is defined by an essentially planar PCB, and the z-axis orthogonally traverses the xy-plane. We may refer to this xy-plane as the reference plane. "Area" of a structure or an object is defined along the xy-plane. Thus, the term area may refer to the area measured along the reference plane or to the area of an orthogonal projection of the object on the reference plane. The term "thickness" refers to a distance measured in the z-axis direction. An essentially even layer of material having a specific thickness may be patterned so that the layer of material is only disposed on selected locations.

The terms location and position refer to location of physical objects on the reference plane. Intended location refers to a location on a plane coplanar with the reference plane into which the physical object is intended to be disposed. Physical objects may reside on different height from the reference plane. The term "collocated" defines that the objects or the orthogonal projections of the objects on the reference plane at least partially overlap. The term "horizontal dimension" refers to a distance measured along an arbitrary straight axis or line along a plane coplanar with the reference plane.

The term "stand-off" refers to a vertical distance (along the z-axis) between a reference plane and an outer surface of a component body nearest to the reference plane, when the leads of the component package touch the reference plane.

The term "blind pad" refers to a pad exposed on a surface of a PCB which does not carry any electrical signal to or from a component disposed above the blind pad. The blind may be connected to any preset electrical potential, preferably to the ground potential, but the electrical potential is not coupled to the component, since there is no galvanic connection between the blind pad and electrically conducting parts of the component before or after soldering.

Terms "leg" and "lead" are equivalent alternatives, both referring to an electrical connection consisting of a length of metal structure that is designed to connect two locations electrically. Metal leads protruding from the component body may be "cut long" and bent to form through-hole pins, or "cut short" and bent to form surface-mount leads. Leads may extend from the lateral sides of the package body and/or they may extend outside the lateral area of the package body.

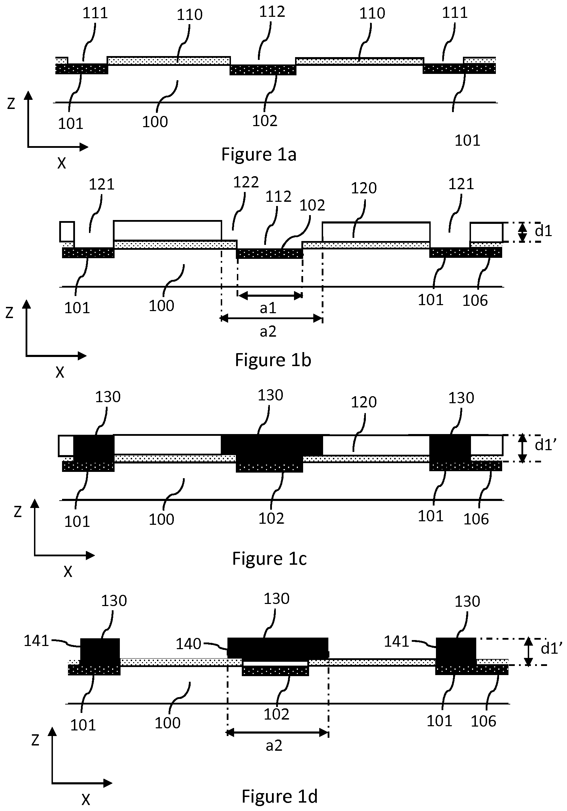

Figures 1a to 1f illustrate cross sections of a PCB installation during a process of assembling a MEMS component according to a first embodiment. Dimensions of the figures are not in scale, but some parts have been exaggerated to improve visualization.

Figure 1a illustrates a cross-section of a plain PCB, showing some main structural features of the PCB needed to understand the process. The PCB comprises non-conductive PCB substrate material 100, such as FR-4 glass epoxy, onto which thin metal layer with conductive pads, traces and other features are laminated onto. This simple example discloses a PCB with just a single layer of metal traces and pads laminated on one side of the PCB, but a person skilled in the art knows that PCB's may have several layers of metal tracks separated by non-conducting PCB material which may be interconnected. The PCB surface is preferably covered by a solder mask 110, which comprises a thin layer of non-conducting material. The purpose of the solder mask 110 is to protect areas of the PCB which are not intended to be soldered during a soldering process. There are openings 111, 112 in the solder mask. The purpose of the openings is to allow connecting components to conductive pin pads 101 and a metal blind pad 102 during the soldering process. Typically, the openings 111, 112 in the solder mask are slightly smaller than the respective pin pads 101 and blind pads 102. The pin pads 101 represent electrical connections on the PCB for leads of components. Typically, the pin pads 101 are made of a thin metal layer exposed on the surface of the PCB. The openings 111 in the solder mask 110 expose pin pads 101, thus enabling attachment of component leads by soldering. The pin pads 101 are preferably coupled to conductive tracks 106 allowing the signals in or out from component leads to be coupled through the PCB. Similar to the pin pads 101, the conductive tracks 106 may comprise a thin metal layer. The conductive tracks 106 may be on surface on the PCB, in which case they may be covered by the solder mask 110 or they may be at least partially buried within the structure of the PCB.

Figure 1a illustrates also the blind pad 102 exposed by the solder mask opening 112, which blind pad 102 is not electrically coupled with any other parts of the PCB. The blind pad 102 may comprise a pattern of thin metal layer laminated on the surface of the PCB. The blind pad 102 and the solder mask opening 112 are essentially collocated and preferably also of equal shape, but may be slightly different in size. In this connection, the shape refers to the shape of the blind pad 102 and the solder mask along a plane coplanar with the reference plane, in other words, shape of an orthogonal projection of the objects on the reference plane. The blind pad 102 is preferably slightly larger than the solder mask opening 112, and therefore the blind pad 102 may be partially covered by the solder mask. However, majority of the blind pad 102 is exposed through the solder mask opening 112 and not covered by the solder mask. The horizontal dimensions of the solder mask opening 112 may be for example 5-10 $\mu$m smaller than the corresponding horizontal dimensions of the blind pad 102. Such slight size difference facilitates tolerances in layer alignment during manufacturing of the PCB, and ensures that the entire solder mask opening 112 exposes metal layer of the blind pad 102.

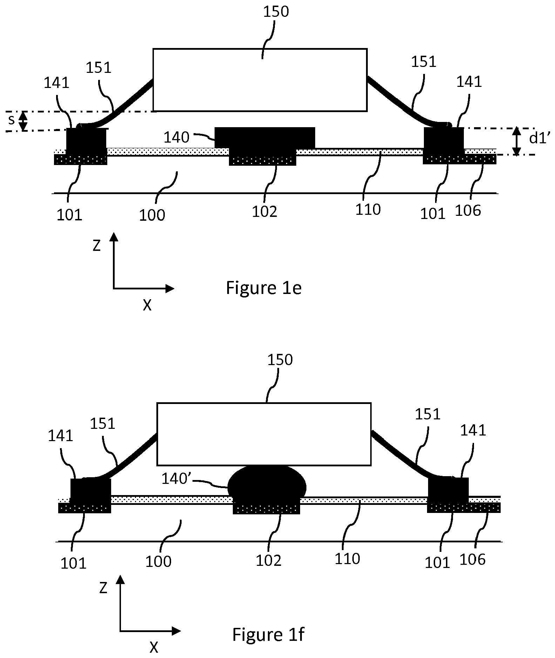

Figure 1b illustrates a stencil 120 placed on the surface of the PCB. The stencil 120 has openings 121, 122 collocated with those of the solder mask 110. As known in the art, an essentially even layer of solder paste may be applied using the stencil so that any openings in the stencil 120 are filled with a layer of solder paste while areas covered by the stencil body do not receive any solder paste. An opening in the stencil may have a size essentially equal to that of the solder mask 110, such as the openings 121 for pin pads 101 in this example. The stencil opening 122 above the blind pad 102 may be bigger than the solder mask opening 112. In this example, the opening in the solder mask has a horizontal dimension of a1, whereas the opening in the stencil has a horizontal dimension of a2. Horizontal dimensions refer to longitudinal dimensions along any straight line defined along an XY-plane, in other words in a plane coplanar with the PCB. By making the stencil opening 122 bigger than that of the respective solder mask opening ensures that sufficient amount of solder paste will be applied to this stencil opening 122 for ensuring good coupling of the package body later in the process. Furthermore, the bigger size of the stencil opening 122 and thus that of the solder pad 140 facilitates both sufficient solder volume to close the vertical gap between the component body 150 and the blind pad 102 surface, and tolerance for inaccuracy in layer alignment during the manufacturing process. Both thickness of the stencil 120 and the horizontal dimensions of the stencil opening 122 are preferably designed to ensure that solder paste molten during the reflow process forms a good mechanical contact with the component package body over the vertical gap. If stand-off of the component body 150, in other words the vertical distance of the component body 150 from the surface of the PCB or, more specifically, from the surface of the blind pad 120, is more than the thickness of the stencil, the horizontal dimensions of the stencil opening may be at least equal to those of the blind pad 102 and/or the solder mask opening 112. An illustration of stand-off is marked in figure 1e with reference s. Preferably, horizontal dimensions of the stencil opening 122 are greater than the respective horizontal dimensions of the respective underlying metal blind pad for improving the success of closing the gap during the controlled heating phase. The absolute size difference is defined by reliability of the generation of good contact in the soldering process. Thus, the horizontal dimension of the opening in the stencil (a2) is greater than the horizontal dimension of the opening in the solder mask (a1):

$$a2 >= 1*a1$$

If the stand-off of the component body is small compared to the stencil thickness so that the stencil is thicker than the stand-off, the stencil opening 122 may be equal to or even smaller than that of the blind pad 102 and/or the solder mask opening 112. In an exemplary design for a standard SOIC package with a stand-off clearly greater than the thickness of the stencil, horizontal dimensions of the stencil opening 122 may be even more than 25% greater than the diameter of the solder mask opening 112. In other words, in this example,

$$a2 >= 1.25*a1$$

In other words, the horizontal dimension of the opening in the stencil (a2) is greater than 1.25 times the horizontal dimension of the opening in the solder mask (a1). Figure 1c illustrates a phase of adding of solder paste 130. The stencil openings 121, 122 and respective collocated solder mask openings 111, 112 are filled with solder paste 130 essentially up to the top surface of the stencil 120. The thickness d1 of the stencil 120 and of the solder mask define the thickness d1' of the layer of solder paste 130 that is applied on each of the stencil openings 121, 122. The volume of the stencil openings 121, 122 and the solder mask openings 111, 112 thus together define the total amount of solder paste 130 applied in the openings on top of the respective pin pad 101 or blind pad 102. An upper limit for the thickness d1 of the stencil and the thickness d1' of the solder paste layer 130 is primarily defined by the amount of solder paste to be deposited on the pin pads 101 for soldering the component leads.

Figure 1d illustrates the PCB after removal of the stencil 120. A pattern of solder paste 130 with maximum thickness d1' of the solder past layer remains on the PCB. The pattern of solder pads 140, 141 made of solder paste 130 is essentially collocated with the solder mask openings. The horizontal dimensions of the solder pad may exceed the horizontal dimensions where needed as illustrated by the solder pad 140. As the dimensions of the solder pad 140 are defined by the stencil opening 122, the horizontal dimensions of the solder pad 140 are essentially equal to that of the stencil, in this case a2. The solder pad 140 is now formed above the blind pad 102, thus collocated with the blind pad 102, and in addition to solder paste patterns 141 configured to join leads of the MEMS component package to the PCB, more specifically to pin pads 101. Figure 1e shows the MEMS component package placed in its intended location. The body 150 of the MEMS component package is placed above the solder pad 140 and the leads 151 are placed on the solder paste patterns 141 disposed on the pin pads 101, into which the leads 151 are temporarily attached by adhesion provided by the solder paste. As explained earlier, at least part of the outer surface of the body 150 is of non-conductive material. For example, the outer surface of the body 150 may include regions made of plastic, ceramic, glass or silicon. Due to its ease of use and low cost, plastic may be considered as the preferred embodiment. The solder material used for the solder pad 140 and the pin pads 141 is preferably a surface-mount device (SMD) industry standard tin-based solder material. Some exemplary variations of such tin-based solder materials include traditional tin-lead based soft solders (SnPb) and lead-free tin-silver-copper alloys (Sn(AgCuX)), wherein "X" stands for at least one of a selection of alloying elements such as In, Ti, Fe, Zn, Bi, Ni, Sb, GA, Al).

Figure 1f illustrates the end result of the method, after the PCB has been exposed to controlled heat in reflow soldering. During the reflow soldering, heat melts the solder paste, which causes the leads 151 to be galvanically joined by soldering with the pin pads 101. When the solder pad 140 melts, it transforms into a rounded solder bump 140' which attaches directly to the bottom of the component package body 150 thus mechanically attaching the body 150 to the blind pad 102 on the PCB. When the controlled heat is removed, the solder bump 140' solidifies, and remains attached with the body 150. The transforming behaviour of the solder pad 140 during heating depends on the amount of solder paste 130 applied to the solder pad 140 as well as characteristics of the solder paste material, for example its surface tension.

By applying a solder pad 140 with horizontal dimensions larger than those of the solder mask opening on the surface of the PCB, the surface tension of the solder pad causes the solder pad to change its three-dimensional shape into a rounded solder bump 140' that reaches the bottom of the body 150 and attaches to it. The smaller than solder pad size of the solder mask opening further facilitates this wanted reshaping of the solder bump 140'. For ensuring a good contact between the body 150 and the blind pad 102, the maximum horizontal dimensions of the solder bump 140' are preferably greater than the respective horizontal dimensions of the solder mask opening 112 or the underlying blind pad 102. In some occasions, the maximum horizontal dimensions of the solder bump 140' may be equal to that of the underlying solder mask opening 112. In such case, the solder bump 140' may be characterised with a three-dimensional shape of a half ball that is flattened at the top where it contacts the body 150. With the maximum horizontal dimensions of the solder bump 140' we refer to the greatest cross-sectional dimensions of the solder bump along a plane coplanar with the PCB. Thus, shape of a cross-section of the rounded solder bump 140' disposed between the essentially flat surfaces of the blind pad 102 and the component body 150, along any plane perpendicular to that of the PCB, is preferably essentially biconvex, as illustrated in figure 1f.

The engagement of the materials at the joint between the solder bump 140' and the non-conductive component package body differs from that of a metal-metal soldering. The joint may be characterized as frictional and/or form fit engagement rather than a permanent solder joint created between metal and solder. The mechanical characteristics of this body-solder joint are suitable for dampening vibrations of the body, but as the component body surface is non-conducting, the body-solder joint does not cause electrical coupling. While the non-conducting body of the component package is not designed for an exposed pad for thermal control, the body-solder joint 140' is not fit for removing heat away from the component body either.

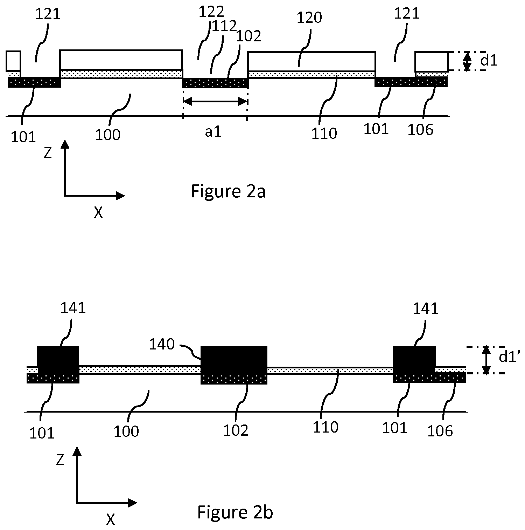

Figures 2a and 2b illustrate a first variation of the process illustrated in figures 1a to 1f. In this second example, the size of the stencil opening 122 essentially equals that of the solder mask opening 112. Except for the size of the stencil opening, the phase of figure 2a corresponds to that of figure 1b, and the phase of figure 2b corresponds to that of figure 1d. The process is thus essentially the same illustrated in figures 1a to 1f, but the horizontal dimensions a1 of the stencil opening 122 and the solder pad 140 are essentially equal to those of the solder mask opening 112. Thickness of the solder pad d1' equals essentially the sum of thickness of the solder mask 110 and thickness d1 of the stencil 120. However, the amount of solder paste may be sufficient for generating the solder bump during the reflow solder melting phase, if the solder paste layer is thick enough and/or the distance between the bottom surface of the component body and the top surface of the blind pad 102 is sufficiently small. The thickness d1' of the solder paste layer to be applied is essentially defined by the stencil thickness d1 and the thickness of the solder mask. The distance of the component body from the top surface of the PCB 100 is defined by the geometrical three-dimensional shape of the component, especially by the relative position of the component body 150 and leads 151.

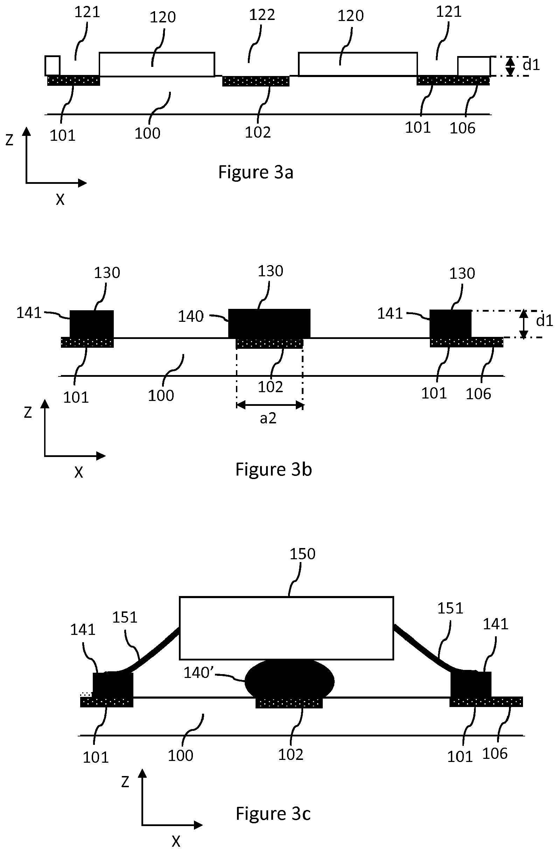

Figures 3a to 3c illustrate a second variation of the process, in which no solder mask is disposed on the surface of the PCB 100. As illustrated in figure 3a, in this third example, the stencil 120 with thickness d1 is applied directly on the top face of the PCB 100 that exposes at least the pin pads 101 and the blind pad 102, with which the stencil openings 121, 122 are collocated. The size of the stencil openings 121, 122 may essentially correspond to the size and location of the pin pads 101 and the blind pad 102. Alternatively, the horizontal dimensions of the stencil opening 122 collocated with the blind pad 102 may be greater than that of the blind pad 102. Otherwise the phase illustrated in figure 3a corresponds to that of figure 1b. Figure 3b shows the phase after first depositing solder paste, 130, corresponding to that illustrated in figure 1c, using the stencil for defining the pattern and the thickness and then removing the stencil. A pattern of solder paste 130 remains which has thickness d1 that essentially equals to that of the stencil. In this third example, the amount of solder paste deposited in the opening (112, 122) may be slightly smaller than that of the examples with a solder mask, since the thickness of the solder paste layer is defined by the stencil thickness d1 only. The horizontal dimensions, such as a2, of the solder pad 140 deposited may however exceed that of the blind pad 102 and thus the amount of solder paste in the solder pad 140 may be increased. Further, by increasing the stencil thickness d1, a thicker solder paste layer may be deposited.

An upper limit for the thickness d1 of the stencil or combined thickness of the solder mask opening and the stencil d1' (and thus that of the solder paste layer 130 deposited) is defined by the amount of solder paste to be deposited on the pin pads 101 for soldering the component leads. Quality of this electrical connection may be compromised if the solder paste layer is too thick. Too much solder paste may decrease the quality of component lead's electrical connections for example by causing unintended short-circuits between adjacent leads. A lower limit for the thickness of the solder paste layer is defined by both reliable electrical contact between the leads and the pin pads and on the other hand, amount of solder paste needed in the solder pad needed to create the solder bump. The minimum and maximum thickness limits of the solder layer for reliable electrical connections depends on various aspects of the PCB layout, composition and materials, and component package design, as well as process variables such as the selected solder paste material and the parameters of the used soldering process, including but not limited to temperature and time related parameters.

Figure 3c illustrates the end result of the third example. The solder bump 140', transformed from the solder pad when subjected to controlled heat, attaches to the blind pad 102 and to the non-conductive bottom of the component body 150 similarly as in the other examples. Similar to figure 1f, shape of a cross-section of the rounded solder bump 140' disposed between the essentially flat surfaces of the blind pad 102 and the component body 150, along any plane perpendicular to that of the PCB, is preferably essentially biconvex. For ensuring a good contact between the body 150 and the blind pad 102, the maximum horizontal dimensions of the solder bump 140' are preferably greater than the respective horizontal dimensions of the underlying blind pad 102. In some occasions, the maximum horizontal dimensions of the solder bump 140' may be equal to that of the underlying blind pad 102. In such case, the solder bump 140' may be characterised by a three-dimensional shape of a half ball that is flattened at the top where it contacts the body 150.

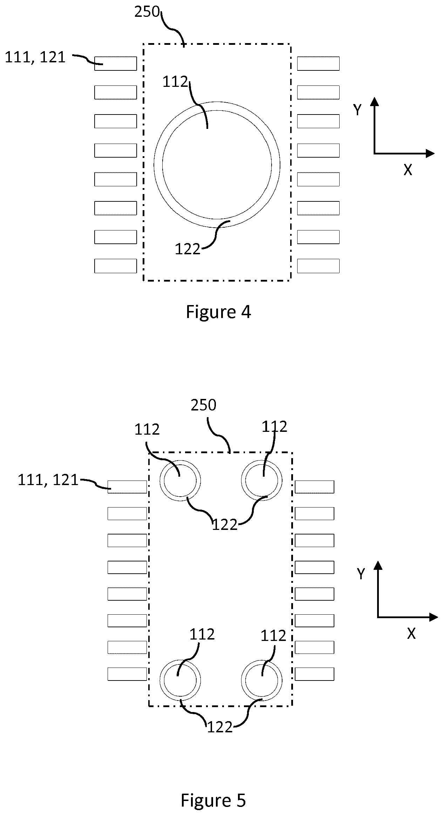

Figure 4 illustrates a first exemplary layout of the solder mask openings 111, 112 on the top surface of a PCB and the corresponding stencil openings 121, 122 according to a first embodiment. The pin pads for attaching the leads of the MEMS component package are exposed through the pin pad openings 111 in the solder mask and through the pin pad openings 121 in the stencil. In this example, these openings for pin pads are quadrangle, but may be of any shape. The shape of an opening refers the shape of the opening along a plane coplanar with the reference plane, in other words, shape of an orthogonal projection of the objects on the reference plane. Pin pad openings 111, 121 in the solder mask and the stencil are collocated and may be essentially equal in size. A blind pad of the PCB is exposed through a circular opening 112 in the solder mask. The blind pad is disposed under the intended location of the component body 250, indicated with a dashed line. The circular opening 122 in the stencil is collocated with the solder mask opening 112, but may be greater in size. In other words, the horizontal dimensions of the stencil opening 122 are greater than those of the solder mask opening 112. Size and location of solder mask openings 111, 112 are preferably slightly larger than that of the pin pads 101 and the blind pad 102. In other words, the solder mask openings may be designed slightly smaller than the respective underlying metal pads. In this example, the horizontal dimensions of a solder mask opening 111, 112 may be 50-100 $\mu$m smaller than the horizontal dimensions of the respective pin pad 101 and the blind pad 102, respectively. This size difference allows small positioning errors of the solder mask on the top surface of the PCB.

If there is no solder mask on the PCB, the pin pad openings 111 and the blind pad opening 112 may be regarded as corresponding to that of the laminated metal pin pads and the blind pad on the surface of the PCB.

In this exemplary embodiment, the component body is attached to the PCB by a single solder pad, which is disposed below the component body approximately in the middle of the package body. In other words, the geometrical center of the solder pad is located in the approximate geometrical center of the package body. As explained above, the preferable relative size of the solder pad depends on the relative heights of the stand-off of the body above the PCB and thickness of the stencil and thus the thickness of the patterned solder paste layer applied.

In this exemplary case of small circular openings under a standard SOIC package, the diameter of the circular stencil opening 122 is preferably at least 25% greater than the diameter of the solder mask opening 112. A circular shape of the openings, causing circular shape of the solder pad applied with the stencil, facilitates reshaping of the solder pad into the preferred, rounded three-dimensional solder bump shape during the reflow solder heating phase. Thus, a circular opening is preferred, although any other shape of the stencil opening 122 and thus the solder pad may be applicable. For example, the shape stencil opening may be rectangular, rectangular with rounded corners or oblong. The shape of an opening refers the shape of the opening along a plane coplanar with the reference plane, in other words, shape of an orthogonal projection of the objects on the reference plane.

Figure 5 illustrates a second exemplary layout of the solder mask openings on a PCB and stencil openings according to a second embodiment. Like in the above embodiment, the conductive pads for attaching the leads of the MEMS component package are exposed through the openings 111 in the solder mask and through the openings 121 in the stencil. These openings 111, 121 are collocated and essentially equal in size. The openings 111, 121 are preferably collocated. The size of the solder mask openings 111 are preferably slightly smaller than the respective pin pads.

Four separate blind pads of the PCB are exposed through circular openings 112 in the solder mask. The blind pads are disposed under the intended location of the component body 250, indicated with a dashed line. The circular openings 122 in the stencil are collocated with the solder mask openings 112, but preferably greater in size. Like the pin pads, the solder mask openings 112 for the blind pads are preferably slightly smaller than the respective underlying metal blind pads to allow slight positioning errors of the solder mask.

In this exemplary embodiment, the component body is attached to the PCB using four solder pads, which are disposed below the component body towards the four corners of the package body. Similar to the first embodiment, the diameters of the circular stencil openings 122 depend at least on the relative vertical heights of the stand-off of the component body 150 and the thickness of the stencil. In this example, designed for a standard SOIC package, the stencil openings 122 may be even equal to the diameter of the solder mask openings 121, but they are preferably at greater than the diameters of the respective circular solder mask openings 112. The circular shape of the openings, thus the circular shape of the applied solder pads facilitates reshaping of the solder pads into the preferred, rounded solder bump shape during the reflow solder heating phase.

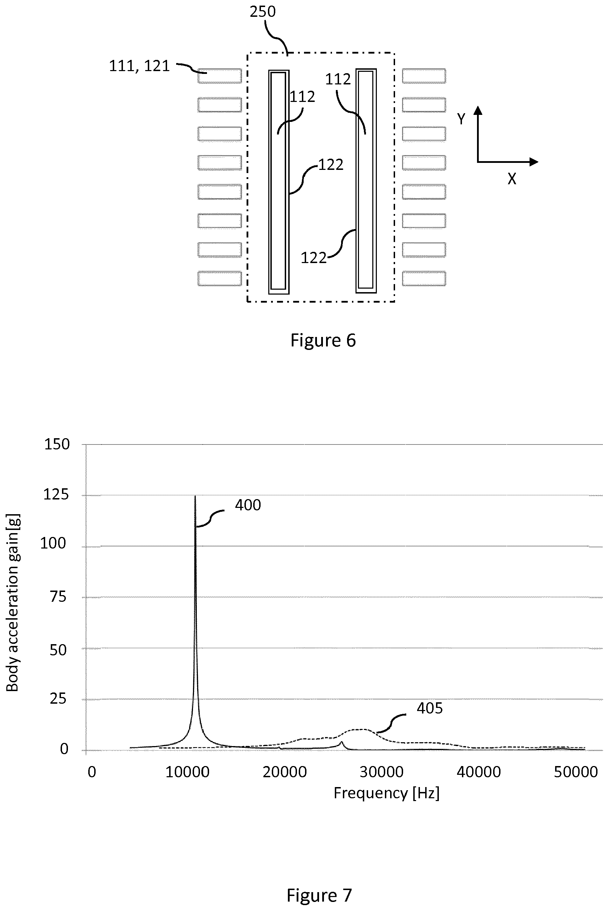

Figure 6 illustrates a third exemplary layout of the solder mask openings on a PCB and stencil openings according to a second embodiment. In this embodiment, there are two oblong, rectangular blind pads exposed through solder mask openings 112. Two separate blind pads of the PCB are exposed through rectangular openings 112 in the solder mask. The blind pads are disposed under the intended location of the component body 250, indicated with a dashed line. The rectangular openings 122 in the stencil are collocated with the solder mask openings 112, but preferably greater in size. The solder mask openings 112 for the blind pads are preferably slightly smaller than the respective underlying metal blind pads to allow slight positioning errors of the solder mask. When exposed to controlled heat in the reflow soldering process, the solder pads will transform into oblong solder bumps with a shape of an oblong rectangle with rounded corners. In a further alternative embodiment, the oblong openings 112, 122 may have a form of a rectangle with rounded corners. The resulting solder bump shape approximately equals to that created with rectangular openings.

If there is no solder mask on the PCB, the pin pad openings 111 and the blind pad opening 112 in figures 4 and 5 may be regarded as corresponding to that of the metal pads on the surface of the PCB.

In a first alternative arrangement, the stencil openings 122 of figures 5 and 6 are collocated with that of the solder mask and the horizontal size of the stencil openings 122 essentially equals that of the solder mask openings 112 for the blind pad.

In a second alternative arrangement, there is no solder mask on the PCB. In such case, the stencil openings 122 are collocated with the blind pads 102 and the horizontal dimensions of the stencil openings 122 may be equal to that of the blind pads 102. Alternatively, the horizontal dimensions of the stencil openings 122 may be greater than that of the blind pads 102.

Figure 7 illustrates measured y-direction body acceleration gain of a component housing with and without solder pads. With the body acceleration gain we mean a ratio between input and output of a vibration test device when it applies vibration on the surface of the component under test. The solid curve (400) illustrates detected y-direction body acceleration gain of a standard SOIC-type component package installed on a PCB in traditional manner, soldering only the surface mount leads of the component package to the PCB. There is a strong resonance peak in the body acceleration gain at a first frequency, in this example on abound 12 kHz frequency. Such resonance is likely to cause significant error to the inertial sensor's output signal due to the high package resonance gain.

By applying at least one solder pad under the component package, the body acceleration gain is reduced so that the maximum y-acceleration gain of the package body is decreased by approximately 90%, and the resonance frequency range is shifted to approximately double the frequency of the standard installation, in this example approximately around range of 28 kHz, as illustrated with the dotted line (405). Shifting the resonance frequency range is beneficial because this way any resonances caused by the component package may be moved away from the critical frequencies, such as the operation frequencies of a MEMS device packed in the component package. One example is to apply the at least one solder pad under a component package body comprising a MEMS gyroscope. By applying the solder pad under the component package, the component package body resonance gain is shifted away from vibration sensitive frequencies of the vibrating MEMS gyroscope structure disposed in the package. Thus, the MEMS gyroscope is less susceptible on producing erroneous detection results due to package resonances. A second example is applying the at least one solder pad under a component body comprising MEMS accelerometer. The gas sealed in the MEMS accelerometer has a damping coefficient that increases as a function of the frequency. Thus, the MEMS accelerometer is less susceptible on producing erroneous detection results due to package resonances. In both examples above, the result is thus that MEMS device produces more accurate detection results and is less susceptible on errors due to package resonances.

It is apparent to a person skilled in the art that as technology advanced, the basic idea of the invention can be implemented in various ways. The invention and its embodiments are therefore not restricted to the above examples, but they may vary within the scope of the claims.

**Claims**

1. A method for installing a MEMS component package comprising a body (150) having outer surfaces of electrically non-conductive material and a plurality of electrically conducting leads (151) protruding from the body (150), the method comprising:

   - applying simultaneously at least one solder pad (140) on at least one blind pad (102) exposed on a printed circuit board surface and solder paste (141) for electrically joining the leads (151) to pin pads (101) exposed on the printed circuit board surface, the at least one blind pad (102) disposed at a location collocated with an intended location of the body (150), and the at least one solder pad (140) collocated with the at least one blind pad (102) on the surface of the printed circuit board (100);
   - placing the MEMS component package on the printed circuit board surface, wherein the solder paste (141) applied for joining the leads (151) temporarily attaches the leads to the pin pads (101) of the printed circuit board (100);
   - subjecting the printed circuit board to controlled heat configured melt the solder paste (141) to electrically couple the leads (151) to the pin pads (101) of the printed circuit board, and to simultaneously melt the at least one solder pad (140), wherein the melting is configured to transform the at least one solder pad (140) into a solder bump (140') that couples the body (150) to the at least one blind pad (102) on the printed circuit board (100), the solder bump (140') attaching with a non-galvanic contact directly to a flat, electrically non-conductive plastic bottom of the body (150).

2. The method according to claim 1, wherein the at least one solder pad (140) and the pin pads (141) are applied using a stencil (120), and vertical distance of the body (150) from the at least one blind pad (102) is greater than the thickness of the stencil (d1), and all maximum horizontal dimensions of the at least one solder pad (140) are equal to or greater than the respective horizontal dimensions of the respective at least one blind pad (102), wherein horizontal dimensions are defined along an arbitrary straight axis (X, Y) or line along a plane coplanar with a reference plane (XY) defined by the printed circuit board (100) and wherein the vertical distance is defined in a direction of an axis (Z) orthogonal to the reference plane.

3. The method according to any of claims 1 to 2, wherein the printed circuit board (100) is coated with a solder mask (110) having at least one opening (112), wherein the at least one solder mask opening (112) is collocated with the respective blind pad (102), and wherein all horizontal dimensions of the at least one solder pad (140) are equal to or greater than respective horizontal dimensions of the solder mask opening (112), wherein horizontal dimensions are defined along an arbitrary straight axis (X, Y) or line along a plane coplanar with a reference plane (XY) defined by the printed circuit board (100).

4. The method according to claim 1, wherein the at least one solder pad (140) and the pin pads (141) are applied using a stencil (120), and vertical distance of the body (150) from the at least one blind pad (102) is equal to or less than thickness of the stencil (d1), and the horizontal dimensions of the at least one solder pad (140) are equal to or less than the respective horizontal dimensions of the respective at least one blind pad (102), wherein horizontal dimensions are defined along an arbitrary straight axis (X, Y) or line along a plane coplanar with a reference plane (XY) defined by the printed circuit board (100) and wherein the vertical distance is defined in a direction of an axis (Z) orthogonal to the reference plane.

5. The method of any of claims 1 to 4, wherein the shape of the at least one blind pad (102) is any one of circular, rectangular and rectangular with rounded corners, and wherein the shape of the at least one solder pad (140) is respectively one of circular, rectangular and rectangular with rounded corners.

6. The method of any of claims 1 to 5, wherein the solder pad (140) transforms into a rounded solder bump (140') when subject to controlled heat, the rounded solder bump (140') having a shape of any one of circular and rounded rectangular.

7. The method according to any of claims 1 to 6, wherein the at least one solder pad (140) comprises the same solder paste material that is applied for joining the leads (151) to the pin pads (101).

8. The method according to any of claims 1 to 7, wherein the printed circuit board comprises a single blind pad (102) disposed under the intended location of the body (150).

9. The method according to any of claims 1 to 7, wherein the printed circuit board comprises two or more blind pads (102) disposed under the intended location of the body (150).

10. The method according to any of claims 1 to 9, wherein the solder paste is any one of a tin-based soft solder and a lead-free tin-silver-copper alloy.

11. A printed circuit board (100) having a MEMS component package (150, 151) installed on it, the MEMS component package comprising a body (150) having outer surfaces of electrically non-conductive material and a plurality of electrically conducting leads (151) protruding from the body (150) and soldered to pin pads (101) of the printed circuit board, the printed circuit board comprising:

  - at least one blind pad (102) of the printed circuit board (100) disposed at a location collocated with the location of the body (150); and
  - at least one solder bump (140') configured to couple the body (150) to the at least one blind pad (102) on the printed circuit board (100), the at least one solder bump (140') attaching with a non-galvanic contact directly to a flat, electrically non-conductive plastic bottom of the body (150).

12. The printed circuit board (100) of claim 11, wherein all maximum horizontal dimensions of the at least one solder bump (140') are equal to or greater than the respective horizontal dimensions of the respective at least one blind pad (102), wherein horizontal dimensions are defined along an arbitrary straight axis (X, Y) or line along a plane coplanar with a reference plane (XY) defined by the printed circuit board (100).

13. The printed circuit board (100) according to any of claims 11 to 12, wherein the printed circuit board (100) is coated with a solder mask (110) having at least one opening (112), wherein the at least one solder mask opening (112) is collocated with the respective blind pad (102), and wherein maximum horizontal dimensions of the solder bump (140') are equal to or greater than respective horizontal dimensions of the solder mask opening (112), wherein horizontal dimensions are defined along an arbitrary straight axis (X, Y) or line along a plane coplanar with a reference plane (XY) defined by the printed circuit board (100).

14. The printed circuit board (100) of any of claims 11 to 13, wherein the at least one blind pad (102) is any one of circular, rectangular and rectangular with rounded corners, and wherein the shape of the at least one solder bump (140') is any one of circular and rounded rectangular.

15. The printed circuit board (100) according to any of claims 11 to 14, wherein the printed circuit board (100) comprises a single blind pad (102) disposed under the intended location of the body (150).

16. The printed circuit board (100) according to any of claims 11 to 14, wherein the printed circuit board (100) comprises at least two blind pads (102) disposed under the intended location of the body (150).

17. The printed circuit board (100) according to any of claims 12 to 16, wherein the solder paste is any one of a tin-based soft solder and a lead-free tin-silver-copper alloy.

**Patentansprüche**

1. Verfahren zum Installieren eines MEMS-Bauelementegehäuses, das einen Körper (150) umfasst, der Außenflächen aus einem elektrisch nicht leitenden Material und mehrere aus dem Körper (150) herausragenden elektrisch leitende Anschlüsse (151) aufweist, wobei das Verfahren umfasst:

  - gleichzeitiges Aufbringen mindestens eines Lötkontakts (140) auf mindestens eine auf einer Leiterplattenoberfläche frei liegende Blindkontaktfläche (102) und einer Lötpaste (141) zum elektrischen Verbinden der Anschlüsse (151) mit auf der Leiterplattenoberfläche frei liegenden Anschlusskontaktflächen (101), wobei die mindestens eine Blindkontaktfläche (102) an einer mit einer geplanten Position des Körpers (150) übereinstimmenden Position angeordnet ist und wobei der mindestens eine Lötkontakt (140) mit der mindestens einen Blindkontaktfläche (102) auf der Oberfläche der Leiterplatte (100) positionsmäßig übereinstimmt;

- Platzieren des MEMS-Bauelementegehäuses auf der Leiterplattenoberfläche, wobei die zum Verbinden der Anschlüsse (151) aufgebrachte Lötpaste (141) die Anschlüsse temporär an den Anschlusskontaktflächen (101) der Leiterplatte (100) fixiert;

- Unterziehen der Leiterplatte einer kontrollierter Wärme, die dazu eingerichtet ist, die Lötpaste (141) zu schmelzen, um die Anschlüsse (151) mit den Anschlusskontaktflächen (101) der Leiterplatte elektrisch zu verbinden und gleichzeitig den mindestens einen Lötkontakt (140) zu schmelzen,

wobei das Schmelzen dazu eingerichtet ist, den mindestens einen Lötkontakt (140) in einen Lötkontakthügel (140') umzuwandeln, der den Körper (150) mit der mindestens einen Blindkontaktfläche (102) auf der Leiterplatte (100) verbindet, wobei der Lötkontakthügel (140') mit einem nichtgalvanischen Kontakt direkt an einem planen, elektrisch nicht leitenden Kunststoffboden des Körpers (150) anhaftet.

2. Verfahren nach Anspruch 1, wobei der mindestens eine Lötkontakt (140) und die Anschlusskontaktflächen (141) mit Hilfe einer Schablone (120) aufgebracht werden und der vertikale Abstand des Körpers (150) zu der mindestens einen Blindkontaktfläche (102) größer als die Dicke der Schablone (d1) ist und alle maximalen horizontalen Abmessungen des mindestens einen Lötkontakts (140) gleich oder größer als die entsprechenden horizontalen Abmessungen der entsprechenden mindestens einen Blindkontaktfläche (102) sind, wobei horizontale Abmessungen entlang einer arbiträren geraden Achse (X, Y) oder Linie entlang einer Ebene, die mit einer durch die Leiterplatte (100) definierten Bezugsebene (XY) koplanar ist, definiert sind, und wobei der vertikale Abstand in Richtung einer orthogonal zur Bezugsebene liegenden Achse (Z) definiert ist.

3. Verfahren nach einem der Ansprüche 1 bis 2, wobei die Leiterplatte (100) mit einer Lötmaske (110), die mindestens eine Öffnung (112) aufweist, beschichtet ist, wobei die mindestens eine Lötmaskenöffnung (112) mit der entsprechenden Blindkontaktfläche (102) positionsmäßig übereinstimmt, und wobei alle horizontalen Abmessungen des mindestens einen Lötkontakts (140) gleich oder größer als die entsprechenden horizontalen Abmessungen der Lötmaskenöffnung (112) sind, wobei horizontale Abmessungen entlang einer arbiträren geraden Achse (X, Y) oder Linie entlang einer Ebene, die mit einer durch die Leiterplatte (100) definierten Bezugsebene (XY) koplanar ist, definiert sind.

4. Verfahren nach Anspruch 1, wobei der mindestens eine Lötkontakt (140) und die Anschlusskontaktflächen (141) mit Hilfe einer Schablone (120) aufgebracht werden und der vertikale Abstand des Körpers (150) zu der mindestens einen Blindkontaktfläche (102) gleich oder kleiner als die Dicke der Schablone (d1) ist und die horizontalen Abmessungen des mindestens einen Lötkontakts (140) gleich oder kleiner als die entsprechenden horizontalen Abmessungen der entsprechenden mindestens einen Blindkontaktfläche (102) sind, wobei horizontale Abmessungen entlang einer arbiträren geraden Achse (X, Y) oder Linie entlang einer Ebene, die mit einer durch die Leiterplatte (100) definierten Bezugsebene (XY) koplanar ist, definiert sind, und wobei der vertikale Abstand in Richtung einer orthogonal zur Bezugsebene liegenden Achse (Z) definiert ist.

5. Verfahren nach einem der Ansprüche 1 bis 4, wobei die Form der mindestens einen Blindkontaktfläche (120) kreisrund, rechteckig oder rechteckig mit abgerundeten Ecken ist und wobei die Form des mindestens einen Lötkontakts (140) entsprechend kreisrund, rechteckig oder rechteckig mit abgerundeten Ecken ist.

6. Verfahren nach einem der Ansprüche 1 bis 5, wobei der Lötkontakt (140) sich unter Einwirkung der kontrollierten Wärme in einen abgerundeten Lötkontakthügel (140') verwandelt, wobei der abgerundete Lötkontakthügel (140') eine kreisrunde oder abgerundete rechteckige Form aufweist.

7. Verfahren nach einem der Ansprüche 1 bis 6, wobei der mindestens eine Lötkontakt (140) das gleiche Lötpastenmaterial umfasst, das zum Verbinden der Anschlüsse (151) mit den Anschlusskontaktflächen (101) aufgebracht wird.

8. Verfahren nach einem der Ansprüche 1 bis 7, wobei die Leiterplatte eine unter der geplanten Position des Körpers (150) angeordnete einzelne Blindkontaktfläche (102) umfasst.

9. Verfahren nach einem der Ansprüche 1 bis 7, wobei die Leiterplatte zwei oder mehr unter der geplanten Position des Körpers (150) angeordnete Blindkontaktflächen (102) umfasst.

**10.** Verfahren nach einem der Ansprüche 1 bis 9, wobei die Lötpaste entweder ein zinnhaltiges Weichlot oder eine bleifreie Zinn-Silber-KupferLegierung ist.

**11.** Leiterplatte (100) mit einem auf ihr installierten MEMS-Bauelementegehäuse (150, 151), wobei das MEMS-Bauelementegehäuse einen Körper (150) umfasst, der Außenflächen aus einem elektrisch nicht leitenden Material und mehrere elektrisch leitende Anschlüsse (151) aufweist, die aus dem Körper (150) herausragen und mit Anschlusskontaktflächen (101) der Leiterplatte (100) verlötet sind, wobei die Leiterplatte umfasst:

- mindestens eine Blindkontaktfläche (102) der Leiterplatte (100), die an einer mit der Position des Körpers (150) übereinstimmenden Position angeordnet ist; und
- mindestens einen Lötkontakthügel (140'), der dazu eingerichtet ist, den Körper (150) mit der mindestens einen Blindkontaktfläche (102) auf der Leiterplatte (100) zu verbinden, wobei der mindestens eine Lötkontakthügel (140') mit einem nichtgalvanischen Kontakt direkt an einem planen, elektrisch nicht leitenden Kunststoffboden des Körpers (150) anhaftet.

**12.** Leiterplatte (100) nach Anspruch 11, wobei alle maximalen horizontalen Abmessungen des mindestens einen Lötkontakthügels (140') gleich oder größer als die entsprechenden horizontalen Abmessungen der entsprechenden mindestens einen Blindkontaktfläche (102) sind, wobei horizontale Abmessungen entlang einer arbiträren geraden Achse (X, Y) oder Linie entlang einer Ebene, die mit einer durch die Leiterplatte (100) definierten Bezugsebene (XY) koplanar ist, definiert sind.

**13.** Leiterplatte (100) nach einem der Ansprüche 11 bis 12, wobei die Leiterplatte (100) mit einer Lötmaske (110), die mindestens eine Öffnung (112) aufweist, beschichtet ist, wobei die mindestens eine Lötmaskenöffnung (112) mit der entsprechenden Blindkontaktfläche (102) positionsmäßig übereinstimmt, und wobei maximale horizontale Abmessungen des Lötkontakthügels (140') gleich oder größer als entsprechende horizontale Abmessungen der Lötmaskenöffnung (112) sind, wobei horizontale Abmessungen entlang einer arbiträren geraden Achse (X, Y) oder Linie entlang einer Ebene, die mit einer durch die Leiterplatte (100) definierten Bezugsebene (XY) koplanar ist, definiert sind.

**14.** Leiterplatte (100) nach einem der Ansprüche 11 bis 13, wobei die mindestens eine Blindkontaktfläche (120) kreisrund, rechteckig oder rechteckig mit abgerundeten Ecken ist und wobei die Form des mindestens einen Lötkontakthügels (140') entweder kreisrund oder abgerundet rechteckig ist.

**15.** Leiterplatte (100) nach einem der Ansprüche 11 bis 14, wobei die Leiterplatte (100) eine einzelne unter der geplanten Position des Körpers (150) angeordnete Blindkontaktfläche (102) umfasst.

**16.** Leiterplatte (100) nach einem der Ansprüche 11 bis 14, wobei die Leiterplatte (100) mindestens zwei unter der geplanten Position des Körpers (150) angeordnete Blindkontaktflächen (102) umfasst.

**17.** Leiterplatte (100) nach einem der Ansprüche 12 bis 16, wobei die Lötpaste entweder ein zinnhaltiges Weichlot oder eine bleifreie Zinn-Silber-Kupfer-Legierung ist.

**Revendications**

**1.** Procédé pour monter un boîtier de composant MEMS comprenant un corps (150) comportant des surfaces extérieures d'un matériau non conducteur d'électricité et une pluralité de pattes (151) conductrices d'électricité débordant du corps (150), ledit procédé comprenant les étapes consistant à

- appliquer simultanément au moins un plot de soudure (140) sur au moins une plage d'accueil factice (102) exposée sur une surface de carte de circuit imprimé et une pâte à souder (141) pour relier électriquement les pattes (151) à des plages de connexion (101) exposées sur la surface de carte de circuit imprimé, ladite au moins une plage d'accueil factice (102) étant disposée à une position colocalisée avec une position prévue du corps (150), et ledit au moins un plot de soudure (140) étant colocalisé avec ladite au moins une plage d'accueil factice (102) sur la surface de la carte de circuit imprimé (100) ;
- placer le boîtier de composant MEMS sur la surface de carte de circuit imprimé, ladite pâte à souder (141) appliquée pour raccorder les pattes (151) attachant les pattes temporairement aux plages de connexion (101) de la carte de circuit imprimé (100) ;
- assujettir la carte de circuit imprimé à une chaleur contrôlée configurée pour mettre en fusion la pâte à souder (141) afin de relier électriquement les pattes (151) aux plages de connexion (101) de la carte de circuit imprimé et, en même temps, mettre en fusion ledit au moins un plot de soudure (140),

ladite mise en fusion étant configurée pour transformer ledit au moins un plot de soudure (140) en une bosse de soudure (140') qui relie le corps (150) à ladite au moins une plage d'accueil factice (102) sur la carte de circuit imprimé (100), ladite bosse de soudure (140') s'attachant avec un contact non galvanique directement à un fond plat en plastique non conducteur d'électricité du corps (150).

**2.** Procédé selon la revendication 1, dans lequel ledit au moins un plot de soudure (140) et les plages de connexion (141) sont appliqués à l'aide d'un pochoir (120), et la distance verticale du corps (150) par rapport à ladite au moins une plage d'accueil factice (102) est supérieure à l'épaisseur du pochoir (d1), et toutes les dimensions horizontales maximales dudit au moins un plot de soudure (140) sont égales ou supérieures aux dimensions horizontales respectives de ladite au moins une plage d'accueil factice (102) respective, lesdites dimensions horizontales étant définies le long d'un axe droit (X, Y) ou d'une ligne droite arbitraire le long d'un plan coplanaire à un plan de référence (XY) défini par la carte de circuit imprimé (100), et ladite distance verticale étant définie dans une direction d'un axe (Z) orthogonal au plan de référence.

**3.** Procédé selon l'une des revendications 1 à 2, dans lequel la carte de circuit imprimé (100) est revêtue d'un masque de soudure (110) comportant au moins une ouverture (112), ladite au moins une ouverture (112) du masque de soudure étant colocalisée avec la plage d'accueil factice (102) respective, et toutes les dimensions horizontales dudit au moins un plot de soudure (140) étant égales ou supérieures aux dimensions horizontales respectives de l'ouverture (112) respective du masque de soudure, lesdites dimensions horizontales étant définies le long d'un axe droit (X, Y) ou d'une ligne droite arbitraire le long d'un plan coplanaire à un plan de référence (XY) défini par la carte de circuit imprimé (100).

**4.** Procédé selon la revendication 1, dans lequel ledit au moins un plot de soudure (140) et les plages de connexion (141) sont appliqués à l'aide d'un pochoir (120), et la distance verticale du corps (150) par rapport à ladite au moins une plage d'accueil factice (102) est égale ou inférieure à l'épaisseur du pochoir (d1), et les dimensions horizontales dudit au moins un plot de soudure (140) sont égales ou inférieures aux dimensions horizontales respectives de ladite au moins une plage d'accueil factice (102) respective, lesdites dimensions horizontales étant définies le long d'un axe droit (X, Y) ou d'une ligne droite arbitraire le long d'un plan coplanaire à un plan de référence (XY) défini par la carte de circuit imprimé (100), et ladite distance verticale étant définie dans une direction d'un axe (Z) orthogonal au plan de référence.

**5.** Procédé selon l'une des revendications 1 à 4, dans lequel la forme de ladite au moins une plage d'accueil factice (120) est l'une parmi circulaire, rectangulaire et rectangulaire aux coins arrondis, et la forme dudit au moins un plot de soudure (140) est respectivement l'une parmi circulaire, rectangulaire et rectangulaire aux coins arrondis.

**6.** Procédé selon l'une des revendications 1 à 5, dans lequel le plot de soudure (140), lorsqu'il est assujetti à la chaleur contrôlée, se transforme en une bosse de soudure arrondie (140'), ladite bosse de soudure arrondie (140') présentant une forme circulaire ou rectangulaire arrondie.

**7.** Procédé selon l'une des revendications 1 à 6, dans lequel ledit au moins un plot de soudure (140) comprend le même matériau de pâte à souder qui est appliqué pour relier les pattes (151) aux plages de connexion (101).

**8.** Procédé selon l'une des revendications 1 à 7, dans lequel la carte de circuit imprimé comprend une seule plage d'accueil factice (102) disposée sous la position prévue du corps (150).

**9.** Procédé selon l'une des revendications 1 à 7, dans lequel la carte de circuit imprimé comprend deux ou plus de deux plages d'accueil factices (102) disposées sous la position prévue du corps (150).

**10.** Procédé selon l'une des revendications 1 à 9, dans lequel la pâte à souder est l'une parmi un alliage de brasage tendre à base d'étain ou un alliage d'étain-argent-cuivre sans plomb.

**11.** Carte de circuit imprimé (100) comportant un boîtier de composant MEMS (150, 151) monté sur celle-ci, ledit boîtier de composant MEMS comprenant un corps (150) comportant des surfaces extérieures d'un matériau non conducteur d'électricité et une pluralité de pattes conductrices d'électricité (151) débordant du corps (150) et brasées sur des plages de connexion (101) de la carte de circuit imprimé (100), ladite carte de circuit imprimé comprenant :

- au moins une plage d'accueil factice (102) de la carte de circuit imprimé (100), disposée à une position colocalisée avec la position du corps (150); et
- au moins une bosse de soudure (140') configurée pour relier le corps (150) à ladite au moins une plage d'accueil factice (102) sur la carte de circuit imprimé (100), ladite au moins une bosse de soudure (140') s'attachant avec un contact non galvanique directement à un fond plat en plastique non conducteur d'électricité du corps (150).

**12.** Carte de circuit imprimé (100) selon la revendication 11, dans laquelle toutes les dimensions horizontales maximales de ladite au moins une bosse de soudure (140') sont égales ou supérieures aux dimensions horizontales respectives de ladite au moins une plage d'accueil factice (102) respective, lesdites dimensions horizontales étant définies le long d'un axe droit (X, Y) ou d'une ligne droite arbitraire le long d'un plan coplanaire à un plan de référence (XY) défini par la carte de circuit imprimé (100).

**13.** Carte de circuit imprimé (100) selon l'une des revendications 11 à 12, dans laquelle la carte de circuit imprimé (100) est revêtue d'un masque de soudure (110) comportant au moins une ouverture (112), ladite au moins une ouverture (112) du masque de soudure étant colocalisée avec la plage d'accueil factice (102) respective, et les dimensions horizontales maximales de la bosse de soudure (140') étant égales ou supérieures aux dimensions horizontales respectives de l'ouverture (112) respective du masque de soudure, lesdites dimensions horizontales étant définies le long d'un axe droit (X, Y) ou d'une ligne droite arbitraire le long d'un plan coplanaire à un plan de référence (XY) défini par la carte de circuit imprimé (100).

**14.** Carte de circuit imprimé (100) selon l'une des revendications 11 à 13, dans laquelle ladite au moins une plage d'accueil factice (102) est circulaire, rectangulaire ou rectangulaire aux coins arrondis, et la forme de ladite au moins une bosse de soudure (140') est circulaire ou rectangulaire arrondie.

**15.** Carte de circuit imprimé (100) selon l'une des revendications 11 à 14, dans laquelle la carte de circuit imprimé (100) comprend une seule plage d'accueil factice (102) disposée sous la position prévue du corps (150).

**16.** Carte de circuit imprimé (100) selon l'une des revendications 11 à 14, dans laquelle la carte de circuit imprimé (100) comprend au moins deux plages d'accueil factices (102) disposées sous la position prévue du corps (150).

**17.** Carte de circuit imprimé (100) selon l'une des revendications 12 à 16, dans laquelle la pâte à souder est l'un parmi un alliage de brasage tendre à base d'étain ou un alliage d'étain-argent-cuivre sans plomb.

111    110    112    110    111

Z

101    100    102

101

Figure 1a

121    122  112  102    120    121

d1

101    100

a1

a2

101  106

Figure 1b

130    130    120    130

d1'

101    100    102

101  106

Figure 1c

130    130    130

141    140    141

d1'

101    100    102

101  106

a2

Figure 1d

150

151                                              151

141                                                      141

s

140

d1'

101    100         102        110      101  106

Z

X                    Figure 1e

150

151                                              151

141                                                      141

140'

101    100         102        110      101  106

Z

X                    Figure 1f

121   122   120   121
112  102

d1

101   100   110   101   106

a1

Z

X

Figure 2a

141   141

140

d1'

101   100   102   110   101   106

Z

X

Figure 2b

Figure 3a

Figure 3b

Figure 3c

Figure 4

Figure 5

Figure 6

Figure 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9691688 B

- US 2014091443 A1